# EUROPEAN PATENT SPECIFICATION

(11) **EP 0 749 207 B1**
(45) Date of publication and mention of the grant of the patent: **27.12.2000**
(21) Application number: 96115344.2
(22) Date of filing: 27.04.1994
(51) Int. Cl.: H03K 5/00, H03K 5/15

(54) **Frequency doubler with NOR gates**
Frequenzverdoppler mit NOR Gattern
Doubleur de fréquence avec portes de type NOR

(30) Priority: 30.04.1993 GB 9308944
(43) Date of publication of application: 18.12.1996
(62) Divisional of application: 94913708.7
(73) Proprietor: STMicroelectronics Limited, Bristol BS12 4SQ (GB)
(72) Inventor: Monk, Trevor Kenneth, Bexley, Kent DA5 3BX (GB); Hall, Andrew Mendlicott, Cotham, Bristol BS6 6AP (GB)
(74) Representative: Driver, Virginia Rozanne

(56) References cited:
- EP-A- 0 282 735
- EP-A- 0 407 082
- US-A- 4 077 010
- US-A- 4 716 308
- US-A- 5 103 114
- INTERNATIONAL JOURNAL OF ELECTRONICS , vol. 48 , no. 1, 1980, LONDON, GB, pages 43-45, XP000608561 KUMAR ET AL.: "A simple digital 2^n frequency multiplier"
- ELECTRONICS, vol. 48, no. 8, 17 April 1975, NEW YORK, US, page 149 XP000608576 MCGAHEE: "Pulse-frequency doubler requires no adjustment"
- IBM TECHNICAL DISCLOSURE BULLETIN, vol. 32, no. 12, May 1990, ARMONK, US, pages 149-151, XP002018731 "Pulse combining network"
- ELECTRONICS, vol. 47, no. 9, 2 May 1974, NEW YORK, US, page 96 XP002018732 TENNY: "Simple gating circuit marks both pulse edges"
- PATENT ABSTRACTS OF JAPAN vol. 008, no. 194 (E-264), 6 September 1984 & JP-A-59 081914 (NIPPON DENKI KK), 11 May 1984,

## Description

The present invention relates to a circuit with a frequency doubler which is capable of receiving four input signals in quadrature and combining them to produce a pair of antiphase output signals at twice the input frequency.

European Patent Application Publication No. 0671086, published under the PCT as WO94/01945, constitutes the state of the art according to Article 54(3) of the EPC, and discloses a phase lock delay line.

International Journal of Electronics, vol. 48, no. 1, 1980, London, GB, pages 43-45 discloses a simple digital frequency multiplier which doubles the frequency of an input signal. The multiplier operates only for a given frequency, depending on predetermined values set for RC filters used in the circuit.

IBM Technical Disclosure bulletin, vol. 32, no. 12, May 1990, pages 149-151, New York, US, "Pulse Combining Network" discloses a frequency doubler circuit which generates true and complement outputs with negligible skew, using complex logic circuitry.

EP 0282735 shows an oscillator generating four signals in quadrature and a frequency doubler comprising NOR gates.

US 5,103,114 shows a circuit to generate a clock signal that has a frequency which is twice the frequency of its input signals, using NAND gates.

US 4 716 308 shows a NOR gate having a switching speed identical for each input.

According to the present invention there is provided in combination, an oscillator arranged to generate first to fourth signals (ø1, ø2, ø3, ø4) which are 90° apart in phase and which have a duty cycle close to 50%, and a frequency doubler circuit comprising:
a first set of logic gates including a first NOR gate (2) connected to receive the first (ø1) and second (ø2) signals, a second NOR gate (4) connected to receive the second (ø2) and third (ø3) signals, a third NOR gate (6) connected to receive the third (ø3) and fourth (ø4) signals and a fourth NOR gate (8) connected to receive the first (ø1) and fourth (ø4) signals; and
a second set of logic gates including a fifth NOR gate (10) connected to receive the outputs (S1,S3) of the first (2) and third (6) NOR gates and a sixth NOR gate (12) connected to receive the outputs (S1,S4) of the second (4) and fourth (8) NOR gates;
wherein the fifth (10) and sixth (12) NOR gates supply as their outputs two signals (OUT1,OUT2) in antiphase at twice the frequency of the input signals.

The switching frequency of the logic gates will limit the maximum operating frequency of the circuit.

The frequency doubler confers a particular advantage when used to double the frequency of quadrature outputs of a quadrature oscillator, which outputs are subject to buffering and conversion. It is usually difficult to make the oscillator, buffer and convertor operate fast enough but with the present frequency doubler they need operate only at a relatively low frequency. The frequency doubler is then the only circuit which is required to run at a high frequency. This is easier to achieve because it can be designed in high speed CMOS logic and could probably have the facility to be powered by a full supply voltage, whereas the oscillator may be restricted to operate at low supply voltages (of less than 3V). An oscillator with which the present invention has particular advantage is described in European Patent Application Publication No. 0648388.

For better understanding of the present invention, and to show how the same may be carried into effect reference will now be made by way of example to the accompanying drawings.
Figure 1 is a circuit diagram of a frequency doubler; and
Figure 2 shows the waveforms of signals in a frequency doubler.

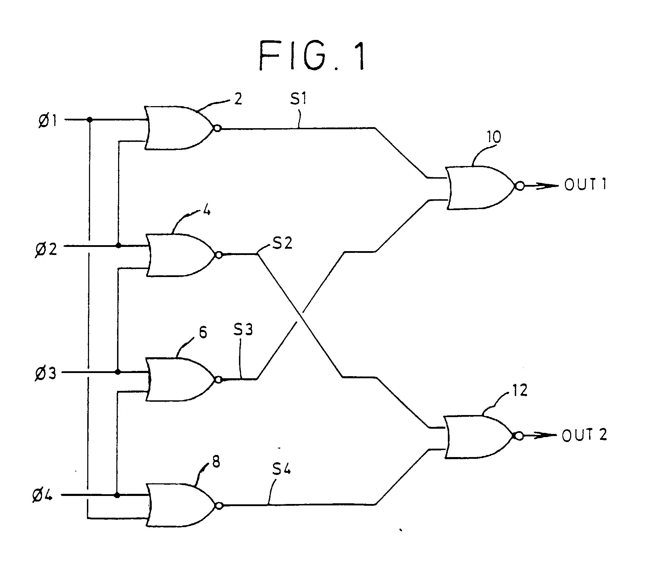

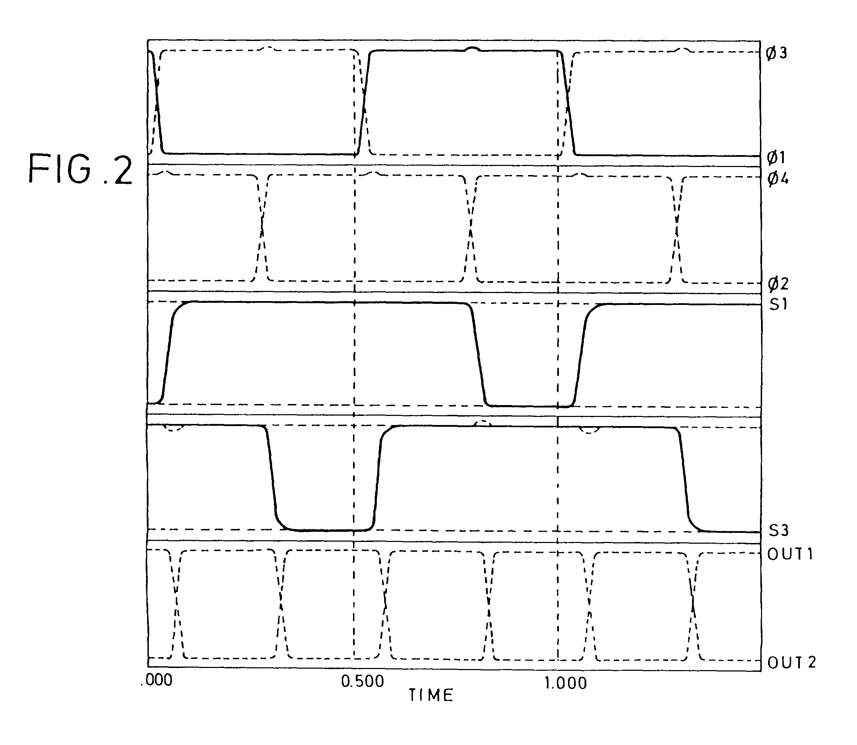

Figure 1 shows a frequency doubler connected to receive 4-phase quadrature signals ø1,ø2,ø3,ø4. The input signals ø1 to ø4 can come for example from CMOS-level convertors which are connected to the outputs of a quadrature oscillator. The input signals ø1 to ø4 are fed to a first layer of NOR gates 2,4,6,8. The first NOR gate 2 receives as its inputs ø1,ø2 which are 90° apart. The second NOR gate 4 receives as its inputs the input signals ø2,ø3 which are 90° apart. The third NOR gate 6 receives the input signals ø3,ø4 which are 90° apart. The fourth NOR gate 8 receives input signals ø1,ø4 which are 90° apart. The timing of the input signals is shown in the top two diagrams of Figure 2 labelled ø1 to ø4 respectively. A second layer of NOR gates comprises fifth and sixth NOR gates 10,12. The fifth NOR gate 10 has as its inputs outputs from the first and third NOR gates 2,6. The sixth NOR gate 12 has as its inputs outputs from the second and fourth NOR gates 4,8. The first layer of NOR gates 2 to 8 combine the inputs ø1 to ø4 to produce four new signals S1 to S4 which go low in turn for 25% of the period. Although the next two diagrams of Figure 2 show intermediate waveform signals S1 and S3 for a frequency doubler that is implemented by means of NAND gates instead of NOR gates, in implementations provided by NOR gates the same output will be received for the four input signals ø1 to ø4. The waveforms for S1 and S3 are shown in Figure 2 but it will be appreciated that S2 and S4 have equivalent waveforms at different parts of the cycle.

The second layer of NOR gates 10,12 combine the signals S1 to S4 to produce a pair of output signals Out1,Out2 which alternate high and low twice in every period of the input signals. Thus, the output is toggling at twice the frequency of the input. This is shown in the last diagram of Figure 2.

For minimum distortion of mark/space ratio, the NOR gates 10,12 of the second layer are best implemented as symmetrical designs, that is the delay from input to output is identical for each input.

A feature of this circuit is that no feedback is required between the layers of NOR gates. Thus, the second layer has as its inputs only inputs from the first layer and the first layer has as its inputs only the 4-phase input signals. There is no feedback from the first layer to the input or from the second layer to the first layer.

## Claims

1. A circuit comprising an oscillator arranged to generate first to fourth signals (ø1,ø2,ø3,ø4) which are 90° apart in phase and which have a duty cycle close to 50%, and a frequency doubler circuit, wherein said frequency doubler circuit comprises:
a first set of logic gates including a first NOR gate (2) connected to receive the first (ø1) and second (ø2) signals, a second NOR gate (4) connected to receive the second (ø2) and third (ø3) signals, a third NOR gate (6) connected to receive the third (ø3) and fourth (ø4) signals and a fourth NOR gate (8) connected to receive the first (ø1) and fourth (ø4) signals; and
a second set of logic gates including a fifth NOR gate (10) connected to receive the outputs (S1,S3) of the first (2) and third (6) NOR gates and a sixth NOR gate (12) connected to receive the outputs (S1,S4) of the second (4) and fourth (8) NOR gates;
wherein the fifth (10) and sixth (12) NOR gates supply as their outputs two signals (OUT1,OUT2) in antiphase at twice the frequency of the input signals.

2. A circuit according to claim 1, wherein the second set of logic gates is symmetric in design so that the delay from input to output is identical for each input.

## Patentansprüche

1. Schaltung, welche einen Oszillator aufweist, der so angeordnet ist, daß er erste bis vierte Signale (Ø1, Ø2, Ø3, Ø4) erzeugt, die um 90° phasenverschoben sind, und die einen Arbeitszyklus nahe bei 50% haben, und eine Frequenzverdopplerschaltung, wobei die Frequenzverdopplerschaltung aufweist:
einen ersten Satz Logikgatter mit einem ersten NOR Gatter (2), das so angeschlossen ist, daß es das erste (Ø1) und zweite (Ø2) Signal empfängt, einem zweiten NOR Gatter (4), das so angeschlossen ist, daß es das zweite (Ø2) und dritte (Ø3) Signal empfängt, einem dritten NOR Gatter (6), das so angeschlossen ist, daß es das dritte (Ø3) und vierte (Ø4) Signal empfängt, und einem vierten NOR Gatter (8), das so angeschlossen ist, daß es das erste (Ø1) und vierte (Ø4) Signal empfängt; und
einen zweiten Satz Logikgatter mit einem fünften NOR Gatter (10), das so angeschlossen ist, daß es die Ausgaben (S1, S3) des ersten (2) und dritten (6) NOR Gatters empfängt, und einem sechsten NOR Gatter (12), das so angeschlossen ist, daß es die Ausgaben (S1, S4) des zweiten (4) und vierten (8) NOR Gatters empfängt;
wobei das fünfte (10) und sechste (12) NOR Gatter als Ausgabe zwei gegenphasige Signale (OUT1, OUT2) mit doppelter Frequenz wie die Eingangssignale liefern.

2. Schaltung gemäß Anspruch 1, bei welcher der zweite Satz Logikgatter symmetrisch aufgebaut ist, so daß die Verzögerung vom Eingang zum Ausgang für jeden Eingang gleich ist.

## Revendications

1. Circuit comprenant un oscillateur disposé pour produire des premier à quatrième signaux (φ1, φ2, φ3, φ4) qui sont déphasés de 90° et ont un rapport cyclique proche de 50 %, et un circuit doubleur de fréquence, dans lequel ledit circuit doubleur de fréquence comprend :
un premier ensemble de portes logiques comprenant une première porte NON OU (2) connectée pour recevoir les premier (φ1) et second (φ2) signaux, une seconde porte NON OU (4) connectée pour recevoir les deuxième (φ2) et troisième (φ3) signaux, une troisième porte NON OU (6) connectée pour recevoir les troisième (φ3) et quatrième (φ4) signaux et une quatrième porte NON OU (8) connectée pour recevoir les premier (φ1) et quatrième (φ4) signaux ; et
un second ensemble de portes logiques comprenant une cinquième porte NON OU (10) connectée pour recevoir les sorties (S1, S3) des première (2) et troisième (6) portes NON OU et une sixième porte NON OU (12) connectée pour recevoir les sorties (S1, S4) des deuxième (4) et quatrième (8) portes NON OU ;
dans lequel les cinquième (10) et sixième (12) portes NON OU fournissent en sortie deux signaux (OUT1, OUT2) en opposition de phase à deux fois la fréquence des signaux d'entrée.

2. Circuit selon la revendication 1, dans lequel le deuxième ensemble de portes logiques est de structure symétrique de sorte que le retard de l'entrée à la sortie est identique pour chacune des entrées.
